# EUROPÄISCHE PATENTSCHRIFT

(11) **EP 0 966 743 B1**
(45) Veröffentlichungstag und Bekanntmachung des Hinweises auf die Patenterteilung: **28.11.2001**
(21) Anmeldenummer: 98912269.2
(22) Anmeldetag: 17.02.1998
(51) Int. Cl.: G11C 29/00

(54) **VERFAHREN ZUM PRÜFEN EINER INTEGRIERTEN SCHALTUNG**
METHOD FOR TESTING AN INTEGRATED CIRCUIT
PROCEDE POUR TESTER UN CIRCUIT INTEGRE

(30) Priorität: 17.03.1997 DE 19711097
(43) Veröffentlichungstag der Anmeldung: 29.12.1999
(73) Patentinhaber: Infineon Technologies AG, 81669 München (DE)
(72) Erfinder: WEIGAND, Roland, D-81549 München (DE); RICHTER, Detlev, D-81827 München (DE)
(74) Vertreter: Zedlitz, Peter, Dipl.-Inf.
(86) Internationale Anmeldenummer: DE9800479
(87) Internationale Veröffentlichungsnummer: WO9841990

(56) Entgegenhaltungen:
- EP-A- 0 053 665
- EP-A- 0 213 037
- EP-A- 0 337 106
- US-A- 5 351 211

## Beschreibung

Zunehmend werden in integrierten Schaltungen neben logischen Schaltungen auch sogenannte integrierte Speicherkerne (embedded memory cores) eingesetzt. Solche Speicher dienen dem Speichern von innerhalb der integrierten Schaltung anfallenden oder von dieser benötigten Daten, während es für die Funktion der integrierten Schaltung nicht notwendig ist, von außerhalb der integrierten Schaltung auf den Speicher zuzugreifen. Ein Test der Funktionsfähigkeit des Speichers ist dennoch notwendig. Für einen ausführlichen Test müssen sowohl die Adressen und Datenmuster algorithmisch erzeugt und an Anschlüsse des Speicher angelegt werden als auch das Zeitverhalten der angelegten Adressen, der zu speichernden Daten und der Steuersignale verändert werden.

Um einen Test eines Speicherkerns durchzuführen, kann es vorgesehen sein, sämtliche Anschlüsse des Speichers zumindest während seiner Prüfung mit externen Anschlüssen der integrierten Schaltung zu verbinden (sogenanntes Freischalten). Dies erfordert jedoch eine große Anzahl von externen Anschlüssen sowie das Vorhandensein eines Speichertesters zum Anschluß an diese externen Anschlüsse, der die notwendigen algorithmischen Testmuster erzeugt.

Eine weitere Möglichkeit zur Durchführung der Funktionsüberprüfung des Speichers ist der sogenannte Built-In Self Test (BIST), einem eingebauten Selbsttest. Durch eine auf der integrierten Schaltung vorgesehene Prüfschaltung, die die Testmuster erzeugt und auch das Timing der entsprechenden Signale festlegt, wird dabei die Prüfung des Speichers vorgenommen. Von Außerhalb der integrierten Schaltung ist dabei eine Einflußnahme auf die Prüfung nicht möglich. Nachdem der Selbsttest vollständig durchgeführt worden ist, ist es dann nur noch erforderlich, ein einziges Ergebnissignal (Go-/No-Go-Signal) nach außerhalb der integrierten Schaltung zu übermitteln, wozu im Extremfall ein einziger Testsignalausgang ausreicht. Diese Lösung hat gegenüber der erstgenannten zwar den Vorteil, eine große Anzahl von Testpins zu vermeiden und ohne eine externe Prüfeinrichtung mit einer großen Zahl von Testanschlüssen auszukommen. Ein BIST hat jedoch den Nachteil, daß für eine gründliche Überprüfung eine große Anzahl verschiedener Testmuster und Zeitverhalten durch die auf der integrierten Schaltung befindliche Prüfschaltung erzeugt werden müssen.

Um bei einem BIST eine Variierung des Timings vornehmen zu können, ist ein großer Aufwand notwendig. U.a. werden hierfür in der entsprechenden Prüfschaltung Timinggeneratoren (beispielsweise in Form von Ringzählern) und Komparatoren benötigt. Insbesondere bei zu prüfenden Speichern mit geringer Speicherkapazität fällt dieser zusätzliche Schaltungsaufwand stark ins Gewicht.

In der EP 0 213 037 A ist ein Speicher gezeigt, der über eine Schaltanordnung mit einer internen Prüfschaltung verbunden ist. Die Schaltanordnung ist von außen gesteuert und verbindet den Speicher in einer Testbetriebsart mit der Prüfschaltung, während er in einer Normalbetriebsart den Speicher mit externen Anschlüssen verbindet.

In der EP 0 053 665 A ist eine integrierte Schaltung mit einem Speicher und einer Testeinrichtung angegeben. Von der Testeinrichtung werden Daten und Adressen über von außerhalb der integrierten Schaltung gesteuerte Gatter dem Speicher zugeführt. Steuersignale werden dem Speicher direkt von außerhalb der integrierten Schaltung zugeführt.

Der Erfindung liegt die Aufgabe zugrunde, ein Prüfverfahren.. für einen integrierten Speicherkern einer integrierten Schaltung anzugeben, bei dem eine Variierung des Timings während des Speichertests auf einfache Weise erfolgt.

Diese Aufgabe wird durch ein Verfahren gemäß Anspruch 1 gelöst.

Zur Durchführung des Speichertests sind Speicher und Prüfschaltung der integrierten Schaltung über Daten-, Adreß- und Steuerleitungen miteinander verbunden, von denen wenigstens eine über ein Schaltmittel geführt ist, das einen Steuereingang aufweist, der mit einem externen Anschluß der integrierten Schaltung verbunden ist. Durch Anlegen eines Signals an den externen Anschluß ist das Schaltmittel durchschaltbar. Somit ist der Signalverlauf auf der entsprechenden Leitung beeinflußbar, so daß der Zeitablauf (Timing) der Prüfung beeinflußbar ist. Die Erfindung bietet den Vorteil, daß ein wenig aufwendiger BIST auf der integrierten Schaltung durchführbar ist, gleichzeitig aber eine Variierung des Timings über die Schaltmittel möglich ist.

Bei einer ersten Ausführungsform der Erfindung ist das Schaltmittel ein logisches Gatter, beispielsweise ein UND-Gatter. Einer der Eingänge des logischen Gatters ist der Steuereingang.

Bei einer anderen Ausführungsform ist das Schaltmittel ein Latch mit einem Takteingang, der der Steuereingang ist.

Besonders günstig ist es, wenn mehrere der Daten- und/oder Adreßleitungen einen Daten- bzw. Adreßbus bilden, alle Leitungen des jeweiligen Busses über je ein Schaltmittel geführt sind und alle Steuereingänge der Schaltmittel jedes Busses mit jeweils demselben externen Anschluß der integrierten Schaltung verbunden sind. Hierdurch erreicht man eine gute Beeinflußbarkeit des Timings bei gleichzeitiger Minimierung der Anzahl an für die Prüfung notwendigen externen Anschlüssen.

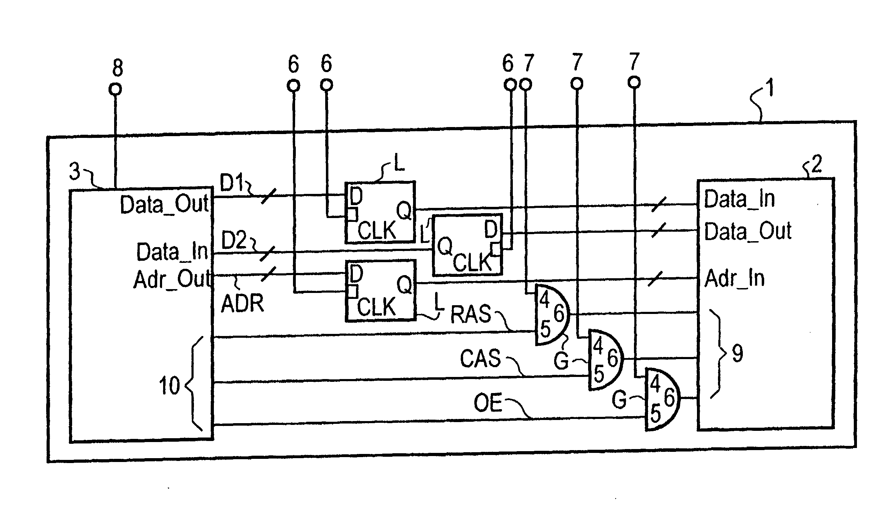

Die Erfindung wird im folgenden anhand der Figur beschrieben, die ein Ausführungsbeispiel der Erfindung darstellt.

Die Figur zeigt eine integrierte Schaltung 1, die einen Speicher 2 als integrierten Speicherkern und eine Prüfschaltung 3 aufweist, die zur Durchführung eines Tests des Speichers 2 dient. Um den Speichertest zu ermöglichen, sind der Speicher 2 und die Prüfschaltung 3 über folgende Leitungen miteinander verbunden:
einen Adreßbus ADR zum Anlegen von von der Prüfschaltung 3 erzeugten Adressen an den Speicher 2 zur Adressierung von Speicherzellen des Speichers 2; einen ersten Datenbus D1, über den einzuschreibende Daten von der Prüfschaltung 3 zum Speicher 2 übertragbar sind; einen zweiten Datenbus D2, über den auszulesende Daten vom Speicher 2 zur Prüfschaltung 3 übertragbar sind (bei anderen Ausführungsbeispielen der Erfindung kann selbstverständlich auch ein einziger, bidirektionaler Datenbus vorgesehen sein); Steuerleitungen RAS, CAS OE, über die entsprechende, für die Ansteuerung des jeweiligen Speichers notwendige Steuersignale von Ausgängen 10 der Prüfschaltung 3 zu entsprechenden Eingängen 9 des Speichers 2 übertragbar sind.

Beim betrachteten Ausführungsbeispiel ist der Speicher 2 ein DRAM, so daß eines der Steuersignale ein Reihenauswahlsignal RAS, ein weiteres ein Spaltenauswahlsignal CAS und ein drittes ein output-enable-Signal OE ist. Bei anderen Ausführungsformen der Erfindung kann dies auch ein Write-enable-Signal WE sein.

Über die beschriebenen Leitungen ist es nun möglich, durch die Prüfschaltung 3 erzeugte, beliebige Testmuster in den Speicher 2 einzuschreiben und aus diesem wieder auszulesen. Als Ergebnis der Überprüfung des Speichers 2 übermittelt die Prüfschaltung 3 nach Abschluß der Überprüfung ein entsprechendes Ergebnissignal an einen dritten externen Anschluß 8 der integrierten Schaltung 1.

Zusätzlich weist die integrierte Schaltung 1 Schaltmittel L, G auf, über die beim gezeigten Ausführungsbeispiel je eine der gezeigten Leitungen D1, D2, ADR, RAS, CAS und OE geführt ist. Beim gezeigten Ausführungsbeispiel sind die Datenleitungen D1, D2 und die Adreßleitungen ADR über taktpegelsensitive Latches L als Schaltmittel geführt. Latches können in einen transparenten und einen intransparenten Zustand geschaltet werden. Sind sie intransparent, wirkt sich eine Signaländerung an ihrem Eingang D nicht auf ihren Ausgang Q aus. Durch Anlegen eines entsprechenden Pegels an einen Takteingang CLK der Latches L sind sie transparent schaltbar, so daß ein Signal am Eingang D auch am Ausgang Q vorliegt. Erfindungsgemäß sind die Takteingänge CLK der Latches L mit ersten externen Anschlüssen 6 verbunden.

Beim Ausführungsbeispiel ist jede der Datenleitungen des ersten Datenbusses D1 und des zweiten Datenbusses D2 sowie jede der Adreßleitungen des Adreßbusses ADR über je ein Latch L geführt. Alle Takteingänge CLK der Latches L desselben Busses D1, D2, ADR sind vorteilhafterweise jedoch mit jeweils demselben ersten Anschluß 6 der integrierten Schaltung 1 verbunden. Über die ersten externen Anschlüsse 6 ist es nun möglich, das Zeitverhalten der von der Prüfschaltung 3 erzeugten Signale oder der aus dem Speicher 2 ausgelesenen Signale zu verzögern, indem das entsprechende Latch L zu einem beliebigen Zeitpunkt transparent geschaltet wird.

Die Steuerleitungen RAS, CAS, OE sind über andere Schaltmittel, nämlich logische Gatter G in Form von UND-Gattern geführt. Dabei ist ein Eingang 4 jedes der Gatter G mit je einem zweiten externen Anschluß 7 der integrierten Schaltung 1 verbunden. Über die zweiten externen Anschlüsse 7 ist es möglich, einen Pegelwechsel der Steuersignale RAS, CAS, OE erst später am Ausgang des jeweiligen Gatters G erscheinen zu lassen.

Mit den erfindungsgemäßen Schaltmitteln L, G ist es möglich, über nur wenige externe Anschlüsse 6, 7 der integrierten Schaltung 1 eine Beeinflussung des gesamten Zeitverhaltens während der Überprüfung des Speichers 2 durch die Prüfschaltung 3 zu bewirken. Zur Erzeugung entsprechender Signale für die externen Anschlüsse 6, 7 bedarf es einer nicht dargestellten Prüfeinrichtung mit nur wenigen Ausgangsanschlüssen, deren Anzahl wesentlich unterhalb derer der Anschlüsse des Speichers 2 liegen kann. Dies kann beispielsweise ein einfacher Logiktester ohne Speichertesteinrichtungen sein, da das Generieren der Adressen der Schreibdaten und das Vergleichen der Lesedaten auf der integrierten Schaltung 1 durch die Prüfschaltung 3 auf der integrierten Schaltung 1 durchgeführt wird. Die geringe Anzahl von externen Testanschlüssen (statt der bis zu 40 Anschlüsse, die bei einem kompletten Freischalten des Speichers 2 auf die Anschlüsse der integrierten Schaltung notwendig wären) ermöglicht ein paralleles Testen mehrerer Chips gleichzeitig auf einfache Weise. Es ist eine ausführliche Analyse des Speichers durchführbar, ohne daß alle seine Datenein- und -ausgänge, Adreßanschlüsse und Steuersignale mit je einem externen Anschluß der integrierten Schaltung 1 verbunden ist.

Während also beim geschilderten Ausführungsbeispiel der Erfindung die Testmuster durch die Prüfschaltung erzeugt werden und auch die ausgelesenen Daten durch die Prüfschaltung 3 überprüft werden, ist über die externen Anschlüsse 6, 7 das Timing der Signale von außerhalb der integrierten Schaltung beeinflußbar. Besonders vorteilhaft ist es, daß für einen kompletten Daten- bzw. Adreßbus nur jeweils ein externer Testanschluß 6 notwendig ist. Über die externen Anschlüsse 6, 7 ist beispielsweise die Länge eines Speicherzyklus oder die zu prüfende Zugriffszeit variierbar.

Die für die Generierung der Testmuster und die Auswertung der ausgelesenen Daten verwendete Prüfschaltung 3 kann entweder als Testgenerator realisiert sein (Hardwarelösung) oder als Testsoftware von dem meist ohnehin auf der integrierten Schaltung vorhandenen Prozessor bzw. Mikrocontroller ausgeführt werden.

Als Schaltmittel zur Beeinflussung des Zeitverhaltens auf den den Speicher 2 und die Prüfschaltung 3 verbindenden Leitungen kann auch jeweils ein Feldeffekttransistor oder ein Transmission Gate (das z.B. durch zwei parallel geschaltete Feldeffekttransistoren gegensätzlichen Kanaltyps, die mit invertierten Signalen ansteuerbar sind, realisierbar ist) vorgesehen sein, dessen Steuergate mit einem externen Anschluß der integrierten Schaltung 1 verbunden ist. Statt der in der Figur gezeigten Latches L können auch taktflankengesteuerte Flip-Flops zur Anwendung kommen.

Die Erfindung hat den weiteren Vorteil, daß der bei einem BIST durch die Prüfschaltung 3 in der Regel fest vorgegebene Prüfablauf auch im Nachhinein noch bezüglich seines zeitlichen Verhaltens über die externen Anschlüsse 6, 7 beeinflußbar ist. Der Aufwand für eine Variierung des Zeitverhaltens der Signale während der Überprüfung durch die Prüfschaltung 3 kann somit durch die Erfindung reduziert werden.

## Patentansprüche

1. Verfahren zum Prüfen einer integrierten Schaltung (1),
- die einen Speicher (2) und eine mit diesem über Datenleitungen (D1, D2), Adreßleitungen (ADR) und Steuerleitungen (RAS, CAS, OE) verbundene Prüfschaltung (3) aufweist,
- bei der wenigstens eine der Steuerleitungen (RAS, CAS, OE) in der Weise über ein Schaltmittel (G) geführt ist, daß ein Signal, das während der Prüfung von der Prüfschaltung auf diese Steuerleitung gegeben wird, an einem Eingang (5) des Schaltmittels (G) anliegt und erst bei einem Durchschalten des Schaltmittels an einen Ausgang (6) des Schaltmittels übertragen wird,
- und deren Schaltmittel (G) einen Steuereingang (CLK; 4) aufweist, über den das Durchschalten des Schaltmittels (G) bewirkbar ist und der mit einem externen Anschluß (7) der integrierten Schaltung (1) verbunden ist,
mit folgenden Schritten:
- der Speicher wird mittels der Prüfschaltung überprüft, indem die Prüfschaltung entsprechende Prüfsignale auf die Datenleitungen (D1, D2), Adreßleitungen (ADR) und Steuerleitungen (RAS; CAS; OE) gibt,
- und während der Prüfung wird der Signalverlauf auf der entsprechenden Steuerleitung (RAS; CAS; OE) und damit der Zeitablauf der Prüfung über den externen Anschluß (7) der Schaltung (1) beeinflußt.

## Claims

1. Method for testing an integrated circuit (1),
- which has a memory (2) and a test circuit (3) which is connected thereto via data lines (D1, D2), address lines (ADR) and control lines (RAS, CAS, OE),
- in which at least one of the control lines (RAS, CAS, OE) is run via a switching means (G) in such a way that a signal which is passed to this control line during testing by the test circuit is present at an input (5) of the switching means (G) and is not transferred to an output (6) of the switching means until the switching means is switched through,
- and whose switching means (G) has a control input (CLK; 4) via which the switching means (G) can be switched through and which is connected to an external terminal (7) of the integrated circuit (1),
having the following steps:
- the memory is checked by means of the test circuit by virtue of the fact that the test circuit passes appropriate test signals to the data lines (D1, D2), address lines (ADR) and control lines (RAS; CAS; OE),
- and during testing the signal profile on the corresponding control line (RAS; CAS; OE) and thus the test time sequences are influenced via the external terminal (7) of the circuit (1).

## Revendications

1. Procédé pour tester un circuit (1) intégré,
- qui comporte une mémoire (2) et un circuit (3) de test relié à celle-ci par l'intermédiaire de lignes (D1, D2) de données, de lignes (ADR) d'adresse et de lignes (RAS, CAS, OE) de commande,
- dans lequel au moins l'une des lignes (RAS, CAS, OE) de commande passe par un moyen (G) de commutation de telle manière qu'un signal, qui a été fourni pendant le test par le circuit de test sur cette ligne de commande, s'applique à une entrée (5) du moyen (G) de commutation et n'est transmis à une sortie (6) du moyen de commutation que lors d'une interconnexion du moyen de commutation,
- et dont les moyens (G) de commutation comportent une entrée (CLK ; 4) de commande par l'intermédiaire de laquelle l'interconnexion du moyen (G) de commutation peut être provoquée et qui est reliée à une borne (7) externe du circuit (1) intégré,
comportant les étapes suivantes :
- on vérifie la mémoire au moyen du circuit de test par le fait que le circuit de test fournit des signaux de tests appropriés sur les lignes (D1, D2) de données, les lignes (ADR) d'adresse et les lignes (RAS ; CCAS ; OE) de commande,
- et, pendant le test, on influence la courbe des signaux sur la ligne (RAS ; CAS ; OE) de commande correspondante et donc le déroulement dans le temps du test par l'intermédiaire de la borne (7) externe du circuit (1).
